# EUROPEAN PATENT APPLICATION

(11) **EP 3 531 555 A1**
(43) Date of publication of application: **28.08.2019**
(21) Application number: 18158165.3
(22) Date of filing: 22.02.2018
(51) Int. Cl.: H03F 1/26, H03F 1/34, H03F 3/183, H03F 3/217

(54) **METHOD FOR SUPPRESSING HIGH FREQUENCY NOISE IN OUTPUT BY A CLASS D AMPLIFIER AND CLASS D AMPLIFIER**

(71) Applicant: Vestel Elektronik Sanayi ve Ticaret A.S., 45030 Manisa (TR)
(72) Inventor: YILMAZLARl, Ismail, 45030 Manisa (TR)
(74) Representative: Thomas, Michael Andrew

(57) **Abstract**

There is provided a method for suppressing high frequency noise in signals (65) output by a class-D amplifier (50), the amplifier (50) having a switching circuit (55), and a low-pass filter (60) to filter signals (95) output by the switching circuit (55). The method comprises: passing signals (65) output by the low-pass filter (60) through a high-pass filter (70) configured to pass a high frequency noise signal (80); attenuating and inverting (75) the high frequency noise signal (80) according to a gain of the amplifier (50); and mixing the attenuated and inverted noise signal with a received audio signal, thereby to input a mixed signal (90) to the amplifier (50). The amplifier (50) amplifies the mixed signal (90) such that the amplified inverted noise signal combines with a high frequency noise signal generated by the switching circuit (55) to result in an output of the switching circuit (55) with reduced high frequency noise.

## Description

### Technical Field

The present disclosure relates to a method for suppressing high frequency switching noise in an output by a class D amplifier and to a class D amplifier.

### Background

A class D amplifier uses switching to amplify a received audio signal. A class D amplifier has a switching circuit that includes a comparator for detecting a difference between an instantaneous signal level of a received audio signal and an instantaneous signal level of a generated high frequency triangular waveform. The instantaneous differences are used to control the switching circuit to generate a high frequency pulse width-modulated (PWM) sequence of pulses. The width of each pulse is determined by the times at which the audio signal level is the same as the modulating signal level.

The output sequence of PWM pulses is passed through a low-pass filter, for example a low-pass filter arranged to pass signals having a frequency below 25 kHz. The low-pass filter removes the high frequency noise components arising from the modulating and switching and thereby recovers the received audio signal, but in an amplified form.

The power levels of signals output by a typical class D amplifier determine that any inductors and capacitors used to implement the low-pass filter are necessarily large in a known class D amplifier.

### Summary

According to a first aspect disclosed herein, there is provided a method for suppressing high frequency noise in signals output by a class-D amplifier, the amplifier having a switching circuit, and a low-pass filter which receives signals output by the switching circuit to provide a filtered audio output signal for playback, the method comprising:
passing signals output by the low-pass filter through a high-pass filter configured to pass a high frequency noise signal;
attenuating and inverting the high frequency noise signal according to a gain of the amplifier; and
mixing the attenuated and inverted noise signal with a received audio signal, thereby to input a mixed audio and inverted noise signal to the amplifier,
wherein the amplifier amplifies the mixed audio and inverted noise signal such that the amplified inverted noise signal combines with a high frequency noise signal generated by the switching circuit to result in an output of the switching circuit with reduced high frequency noise.

By providing a feedback loop in the class D amplifier to generate an inverted form of any noise that is passed by the low-pass filter, high frequency noise arising from the modulating function of the switching circuit is cancelled after amplification of the corresponding but inverted noise in the signal that is input to the amplifier.

In an example, the method comprises mixing the attenuated and inverted noise signal with the received audio signal thereby to generate the mixed audio and inverted noise signal at an input to the amplifier.

In an example, the method comprises mixing the attenuated and inverted noise signal with the received audio signal in a digital signal processor thereby to generate the mixed audio and inverted noise signal for input to the amplifier.

In an example, the method comprises measuring the attenuated and inverted noise signal and thereafter generating an inverted noise signal corresponding to the measured signal and combining the generated inverted noise signal with a received audio signal thereby to generate a mixed audio and inverted noise signal for input to the amplifier. By generating the inverted noise signal in the digital signal processor, a noise signal no longer needs to be supplied via the high-pass filter.

In an example, the method comprises attenuating and inverting the signal output by the low-pass filter before passing the attenuated and inverted signal output to the high-pass filter.

In this way, a lower power signal may be passed to the high-pass filter enabling the high-pass filter to be implemented with smaller and lower-power components.

In an example, the amplifier amplifies signals with a gain G and the attenuating and inverting attenuates and inverts signals by a factor -*1*/*G*. This ensures that, following amplification with gain G, the amplified inverted noise signal is of substantially the same magnitude as the noise component appearing in the output of the low-pass filter.

In an example, the high-pass filter is arranged to pass noise signals having a frequency of more than 50 kHz.

According to a second aspect disclosed herein, there is provided a class D amplifier, comprising:
an input for receiving an audio signal to be amplified;
a switching circuit;
a low-pass filter arranged to receive signals output by the switching circuit;
a high-pass filter; and
an attenuator,
the amplifier being configured:
   to pass signals output by the low-pass filter to the high-pass filter, the signals comprising an amplified received audio signal and a high frequency noise signal;
   to pass a high frequency noise signal filtered by the high-pass filter from the signals output by the low-pass filter to the attenuator to attenuate and to invert the high frequency noise signal; and
   to pass the resultant attenuated and inverted noise signal to be mixed with a received audio signal at the input to the amplifier, and
wherein the switching circuit thereby amplifies the mixed audio and inverted noise signal such that the amplified inverted noise signal combines with a high frequency noise signal generated by the switching circuit to result in an output of the switching circuit with reduced high frequency noise.

In an example, the class D amplifier is arranged such that the attenuated and inverted noise signal is mixed with a received audio signal at the input to the amplifier.

In an example, the class D amplifier is arranged such that the attenuated and inverted noise signal is mixed with the received audio signal in a digital signal processor thereby to generate the mixed audio and inverted noise signal for input to the amplifier.

In an example of the class D amplifier, the digital signal processor is configured to measure the attenuated and inverted noise signal and thereafter to generate an inverted noise signal corresponding to the measured signal and to combine the generated inverted noise signal with a received audio signal thereby to generate a mixed audio and inverted noise signal for input to the amplifier.

In an example of the class D amplifier, the attenuator is connected to receive the signals output by the low-pass filter before passing the attenuated and inverted signals to the high-pass filter to pass an attenuated and inverted high frequency noise signal to be mixed with a received audio signal.

In an example of the class D amplifier, the amplifier is arranged to amplify signals with a gain *G* and the attenuator is arranged to attenuate and to invert signals by a factor -*1*/*G*.

In an example of the class D amplifier, the high-pass filter is arranged to pass high frequency noise signals having a frequency of more than 50 kHz.

In an example of the class D amplifier, the low-pass filter is arranged to pass signals including at least a portion of a high frequency noise signal generated by the switching circuit having a frequency of more than 20 kHz.

### Brief Description of the Drawings

To assist understanding of the present disclosure and to show how embodiments may be put into effect, reference is made by way of example to the accompanying drawings in which:
Figure 1 shows schematically a known class D amplifier in use for amplifying a received audio signal;
Figure 2 shows schematically an example of a class D amplifier according to the present disclosure; and
Figure 3 shows in three graphs how noise components in amplified signals may be suppressed in an example of a class D amplifier according to the present disclosure.

### Detailed Description

Conventional Class D amplifiers include a passive low-pass filter at the output of the switching stage to remove high frequency switching or modulation signal components and thereby output only the amplified audio signal, to a loudspeaker for example. At the relatively high power levels involved, the low-pass filter components are required to be physically large, for example comprising one or more of a high power resistor, a large inductor and a high capacitance capacitor. This is a particular problem in mobile and handheld devices, as the space available for components in such devices is limited. However, if small output filtering components are used at the output of the amplifier, in particular if a smaller resistor and/or inductor and smaller capacitance capacitor are used, some high frequency modulation signal components may reach the loudspeaker.

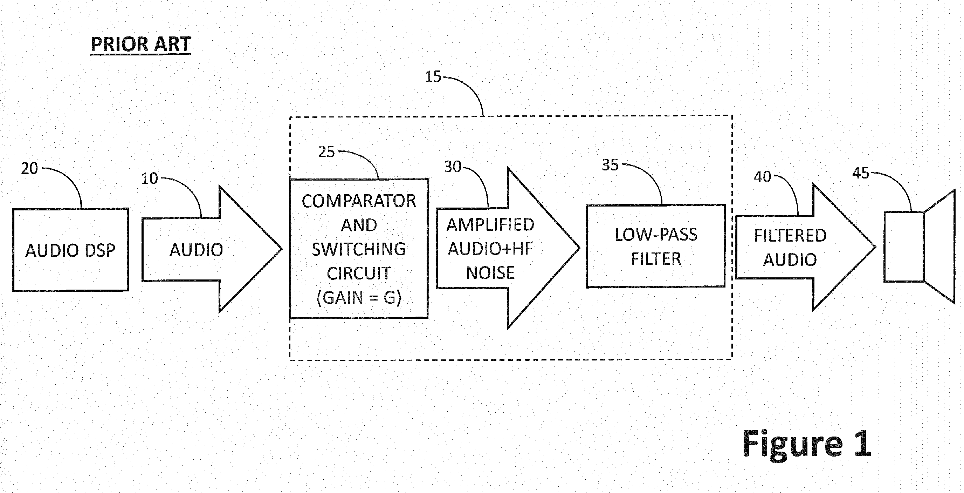

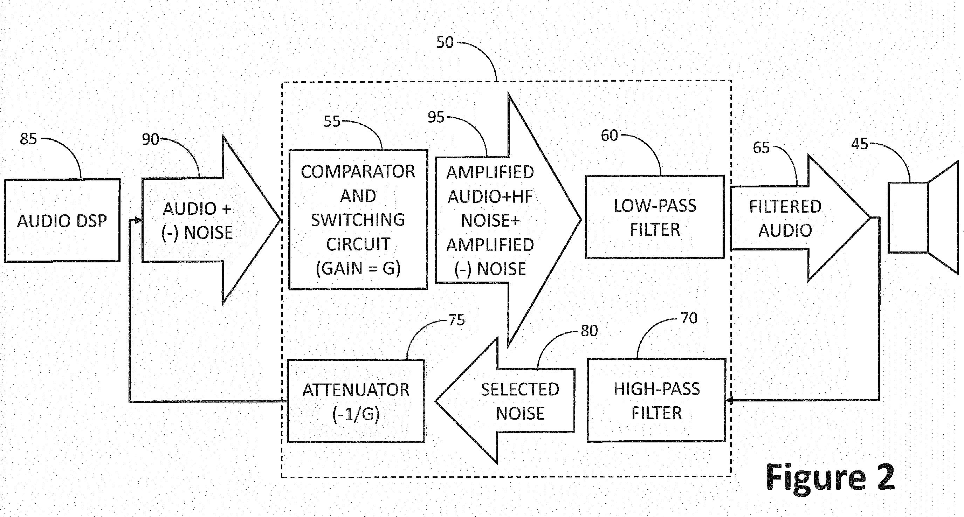

A block diagram showing an example of a typical conventional Class D amplifier arrangement will firstly be described with reference to Figure 1. An example of a Class D amplifier arrangement according to the present disclosure will then be described with reference to Figure 2.

Referring initially to Figure 1, an input audio signal 10, which is to be amplified for output to one or more loudspeakers, is input to a class D amplifier 15 from a digital signal processor (DSP) 20, for example, or other analogue audio signal source. The class D amplifier 15 comprises a switching circuit 25, arranged to generate a pulse width-modulated (PWM) stream of pulses representing an amplified form 30 of the received audio 10, and a low-pass filter 35. The width of each PWM pulse in the amplified audio 30 is determined by a comparator of the switching circuit 25, measuring an instantaneous difference between the signal level of the analogue audio 10 and the signal level of a high frequency (typically > 100 kHz) modulating triangular pulse signal generated within or supplied to the switching circuit 25.

The PWM pulses of the amplified audio 30 are passed through the low-pass filter 35 to remove higher frequency modulating and switching components from the PWM audio output 30 and thereby recover the input analogue audio signal, but in amplified form. The low-pass filter 35 may for example comprise a resistor, inductor and capacitor network with components selected to pass signals with a frequency of less than 25 kHz. The filtered and amplified audio signal 40 is output from the amplifier 15 and passed to a loudspeaker 45 or other audio transducer.

Conventionally, the components used for the low-pass filter 35, for example one or more of a resistor, an inductor and capacitor, are selected to be able to handle the high output power levels of signals output by a typical class D amplifier. As such the or each resistor and/or inductor is physically large and the or each capacitor has a high capacitance and is therefore also physically large.

Referring now to Figure 2, an example of a class D amplifier 50 according to the present disclosure comprises a switching circuit 55 and a low-pass filter 60. The switching circuit 55 includes a modulating signal generator or an input for receiving a modulating signal generated elsewhere. The modulating signal typically comprises a high frequency triangular pulse stream, for example at a frequency of between 200 kHz and 500 kHz. The switching circuit 55 includes a comparator (not shown in Figure 2) for continuously detecting an instantaneous difference between the modulating pulse signal level and the signal level of a received analogue audio signal. The detected difference in signal level at each pulse is used to control the switching times of the switching circuit 55 and hence the width of pulses output by the switching circuit 55. That is, when the detected difference between the audio signal level and the modulating signal level is zero, the switches of the switching circuit 55 change state. The switching circuit 55 thereby generates a square-wave PWM pulse stream wherein the width of each pulse is representative of an amplified signal level of the received audio signal where it intersects the rising and falling slope of the respective modulating pulse.

The low-pass filter 60 removes at least some of the high frequency modulating and switching noise from the high frequency PWM pulse stream output by the switching circuit 55 to leave a filtered analogue audio signal 65 with some high frequency noise still present.

The amplifier 50 is also provided with a high-pass filter 70 connected to receive the filtered audio signal 65 output from the amplifier 50, and an attenuator 75. The high-pass filter 70 is arranged for example to pass signals having a frequency greater than 50 kHz. The high-pass filter 70 thereby removes the amplified audio component from the filtered audio signal 65 to leave only higher frequency switching and modulating noise components that were not suppressed by the low-pass filter 60. The high frequency noise signal 80 output by the high-pass filter 70 is then passed to the attenuator 75 to attenuate the noise signal by a factor -*1*/*G*, where *G* is the gain of the switching circuit 55 of the amplifier 50.

The filtered and attenuated noise signal is introduced at the input to the amplifier 50, for example at the output of an audio DSP 85, to be mixed with an incoming audio signal. Alternatively, the filtered and attenuated noise signal may be mixed with a received audio signal by the audio DSP 85 resulting in a signal 90 at the input to the amplifier 50 comprising an audio signal with an inverted noise component added to the audio signal waveform.

The mixed signal 90 is input to the switching circuit 55 and a corresponding PWM pulse stream 95 is output. However, the inverted noise component that was added to the audio signal slightly alters the width of each PWM pulse from a pulse width that would have been generated without the inverted noise signal being present. The effect of this is that the noise generated by modulation and switching in the switching circuit 55 is effectively cancelled or at least reduced by the inverted noise component after amplification with gain *G*. Therefore, when the PWM pulse stream 95 output by the switching circuit 55 is filtered by the low-pass filter 60, the noise component that would have been passed by the low-pass filter 60 is no longer represented in the PWM pulse stream 95. A noise-free audio signal 65, or at least an audio signal 65 having reduced noise, may therefore be passed to the one or more loudspeakers 45.

The presence of a feedback loop through the high-pass filter 70 and the attenuator 75 enables smaller and lower power filtering components to be used in the low-pass filter 60 as compared with those used in the low-pass filter 35 of a conventional amplifier 15. The low-pass filter 60 will therefore have a higher cut-off frequency than the 25 kHz cut-off frequency of the conventionally used low-pass filter 35, so allowing some higher frequency modulation components to pass. The feedback loop enables those high frequency noise signals passed by the low-pass filter 60 to be cancelled or at least reduced in the switching circuit 55.

In an example, initially the amplifier 50 may be operated without adding the negative feedback from the high-pass filter 70 and the attenuator 75, so as to find an initial value for the noise which is then divided by the gain *G* and subtracted from the output of the audio DSP 85. This may be repeated as necessary if the gain *G* changes (or at least changes significantly), because for example the user increases or decreases the volume significantly. Alternatively, the amplifier 50 may use a PI (proportional control) feedback loop so as to provide a more active, continuous operation and in particular to keep zero modulation noise at the terminals of the loudspeaker 45. A proportional control block maybe added before or after the attenuator 75 or the high pass filter 70. In the proportional control algorithm, the controller output is proportional to the error signal. The noise at the terminals of the loudspeaker 45 may be used as an error signal.

If necessary, alternatively or additionally a short adjustable delay may be introduced into the feedback loop through the high-pass filter 70 and the attenuator 75 to ensure that the high frequency modulating components represented in the high frequency noise signal are in phase with the modulating signal generated within or for use by the switching circuit 55.

The positions of the high-pass filter 70 and the attenuator 75 may be interchanged so that the filtered audio signal 65 passes firstly through the attenuator 75 before being passed to the high-pass filter 70. A lower-power signal is thereby passed to the high-pass filter 70, enabling smaller and lower-power components to be used for the high-pass filter 70.

In an example implementation, the DSP 85 may be arranged to measure the substantially unvarying attenuated and inverted noise signal when output by the combination of the attenuator 75 and the high-pass filter 70, for example during a configuration stage of the amplifier 50. The DSP 85 may be configured thereafter to generate a substantially identical inverted noise signal and to add the generated inverted noise signal to received audio signals without needing to receive an attenuated and inverted noise signal through the feedback loop.

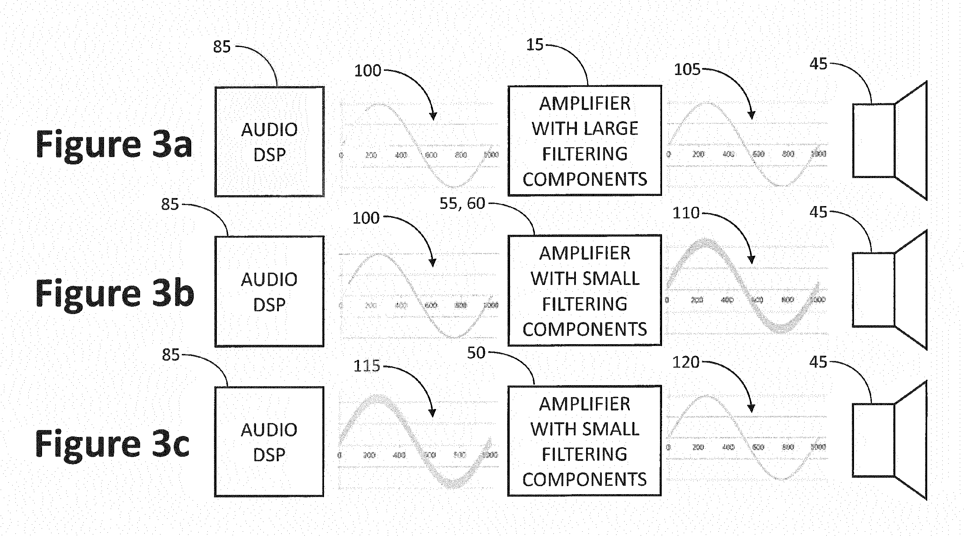

As a demonstration of the benefits of the class D amplifier 50 according to the present disclosure, reference will now be made to Figure 3 in which the benefits are illustrated in an example.

Referring to Figure 3, three scenarios are shown.

Figure 3a shows how a portion of an audio signal 100 output by the audio DSP 85 results in an amplified audio signal 105 being output to the loudspeaker 45 from a conventional class D amplifier 15 having a low-pass filter 35 with large filtering components. The amplified audio signal 105 is substantially free of high-frequency noise.

Figure 3b shows how the same portion of an audio signal 100 would result in an amplified audio signal 110 including some higher frequency noise being output to the loudspeaker 45, when the class D amplifier is the same as in Figure 1 but comprises a low-pass filter 60 with small filtering components.

Figure 3c shows how an audio signal from an audio DSP 85, when mixed 115 with an attenuated and inverted noise signal would result in an amplified audio signal 120 being output to the loudspeaker 45 when the class D amplifier is a class D amplifier 50 as described above according to the present disclosure. The amplified audio signal 120 is substantially free of noise, although the low-pass filter 60 comprises only small filtering components which would otherwise allow a portion of high frequency noise to pass to the loudspeaker 45.

This can be summarised for these three cases by the following table:

| | Input to Switching Circuit | Output to Loudspeaker |
|---|---|---|
| Case 1 (Figure 3a) | A/G | A |
| Case 2 (Figure 3b) | A/G | A+N |
| Case 3 (Figure 3c) | A/G - N/G | A |

where A is the audio signal output to the loudspeaker(s) 45, G is the gain applied by the amplifier 50 and N is the high frequency noise, as discussed more fully above.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A method for suppressing high frequency noise in signals (65) output by a class-D amplifier (50), the amplifier (50) having a switching circuit (55) and a low-pass filter (60) which receives signals (95) output by the switching circuit (55) to provide a filtered audio output signal for playback, the method comprising:
passing signals (65) output by the low-pass filter (60) through a high-pass filter (70) configured to pass a high frequency noise signal (80);
attenuating and inverting (75) the high frequency noise signal (80) according to a gain of the amplifier (50); and
mixing the attenuated and inverted noise signal with a received audio signal, thereby to input a mixed audio and inverted noise signal (90) to the amplifier (50),
wherein the amplifier (50) amplifies the mixed audio and inverted noise signal (90) such that the amplified inverted noise signal combines with a high frequency noise signal generated by the switching circuit (55) to result in an output of the switching circuit (55) with reduced high frequency noise.

2. The method according to claim 1, comprising mixing the attenuated and inverted noise signal with the received audio signal thereby to generate the mixed audio and inverted noise signal (90) at an input to the amplifier (50).

3. The method according to claim 1, comprising mixing the attenuated and inverted noise signal with the received audio signal in a digital signal processor (85) thereby to generate the mixed audio and inverted noise signal (90) for input to the amplifier (50).

4. The method according to any of claims 1 to 3, comprising measuring the attenuated and inverted noise signal and thereafter generating an inverted noise signal corresponding to the measured signal and combining the generated inverted noise signal with a received audio signal thereby to generate a mixed audio and inverted noise signal (90) for input to the amplifier (50).

5. The method according to any of claims 1 to 4, comprising attenuating and inverting (75) the signal (65) output by the low-pass filter (60) before passing the attenuated and inverted signal to the high-pass filter (70).

6. The method according to any of claims 1 to 5, wherein the amplifier (50) amplifies signals (90) with a gain G and wherein the attenuating and inverting (75) attenuates and inverts signals by a factor -*1*/*G*.

7. The method according to any of claims 1 to 6, wherein the high-pass filter (70) is arranged to pass noise signals (80) having a frequency of more than 50 kHz.

8. A class D amplifier (50), comprising:
an input for receiving an audio signal to be amplified;
a switching circuit (55);
a low-pass filter (60) arranged to receive signals (95) output by the switching circuit (55);
a high-pass filter (70); and
an attenuator (75),
the amplifier (50) being configured:
to pass signals (65) output by the low-pass filter (60) to the high-pass filter (70), the signals (65) comprising an amplified received audio signal and a high frequency noise signal;
to pass a high frequency noise signal (80) filtered by the high-pass filter (70) from the signals (65) output by the low-pass filter (60) to the attenuator (75) to attenuate and to invert the high frequency noise signal (80); and
to pass the resultant attenuated and inverted noise signal to be mixed (90) with a received audio signal at the input to the amplifier (50), and
wherein the switching circuit (55) thereby amplifies the mixed audio and inverted noise signal (90) such that the amplified inverted noise signal combines with a high frequency noise signal generated by the switching circuit (55) to result in an output of the switching circuit (55) with reduced high frequency noise.

9. The class D amplifier (50) according to claim 8, arranged such that the attenuated and inverted noise signal is mixed with a received audio signal at the input to the amplifier (50).

10. The class D amplifier (50) according to claim 8, arranged such that the attenuated and inverted noise signal is mixed with a received audio signal in a digital signal processor (85) thereby to generate the mixed audio and inverted noise signal (90) for input to the amplifier (50).

11. The class D amplifier (50) according to claim 10, wherein the digital signal processor (85) is configured to measure the attenuated and inverted noise signal and thereafter to generate an inverted noise signal corresponding to the measured signal and to combine the generated inverted noise signal with a received audio signal thereby to generate a mixed audio and inverted noise signal (90) for input to the amplifier (50).

12. The class D amplifier (50) according to any of claims 8 to 11, wherein the attenuator (75) is connected to receive the signals (65) output by the low-pass filter (60) before passing the attenuated and inverted signals to the high-pass filter (70).

13. The class D amplifier (50) according to any of claims 8 to 12, wherein the amplifier (50) is arranged to amplify signals with a gain G and wherein the attenuator (75) is arranged to attenuate and to invert signals by a factor -*1*/*G*.

14. The class D amplifier (50) according to any of claims 8 to 13, wherein the high-pass filter (70) is arranged to pass high frequency noise signals (80) having a frequency of more than 50 kHz.

15. The class D amplifier (50) according to any of claims 8 to 14, wherein the low-pass filter (60) is arranged to pass signals (80) including at least a portion of a high frequency noise signal generated by the switching circuit (55) having a frequency of more than 20 kHz.
